# EUROPÄISCHE PATENTANMELDUNG

(11) **EP 0 776 152 A1**
(43) Veröffentlichungstag der Anmeldung: **28.05.1997**
(21) Anmeldenummer: 96117803.5
(22) Anmeldetag: 07.11.1996
(51) Int. Cl.: H05K 7/14

(54) **Haltevorrichtung fur eine Steckkarte**

(30) Priorität: 25.11.1995 DE 19544069
(71) Anmelder: Funk Dreidimensional Entwicklungs- und Vertriebs GmbH, 72226 Simmersfeld (DE)
(72) Erfinder: Renner, Dieter, 72213 Altensteig (DE); Braun, Michael, 72202 Nagold-Minderbach (DE); Lang, Thomas, 72229 Rohrdorf (DE); Funk, Walter, 72226 Simmersfeld (DE); Stahl, Hermann, 71711 Steinheim (DE); Kärcher, Klaus, 71723 Grossbottwar (DE)
(74) Vertreter: Fleck, Hermann-Josef, Dr.-Ing.

(57) **Zusammenfassung**

Die Erfindung bezieht sich auf eine Haltevorrichtung für eine in einen Steckplatz eingesetzte Steckkarte. Eine sichere und dauerhafte Festlegung der Steckkarte wird dadurch erzielt, daß die Haltevorrichtung gekennzeichnet ist durch ein im Bereich des Aufnahmeschlitzes anbringbares Koppelteil, ein an dem von dem Steckplatz abgekehrten Ende der Steckkarte festlegbares Haltestück und
ein an dem Koppelteil und dem Haltestück angebrachtes oder anbringbares Spannstück, mit dem der Abstand zwischen dem Koppelteil und dem Haltestück verkürzbar ist.

## Beschreibung

Die Erfindung bezieht sich auf eine Haltevorrichtung für eine in einen Aufnahmeschlitz gesteckte Steckkarte.

Bei derartigen Haltevorrichtungen werden bisher die Steckkarten gegen Herausfallen aus einem Aufnahmeschlitz in der Nähe desselben gesichert. Längere Karten können sich beim Transport herauslösen, wodurch sich verschiedene Komplikationen ergeben können.

Der Erfindung liegt die Aufgabe zugrunde, eine Haltevorrichtung der eingangs genannten Art bereitzustellen, die auf einfache Weise eine in einen Aufnahmeschlitz gesteckte Steckkarte zuverlässig gegen ein Herauslösen sichert.

Diese Aufgabe wird mit den Merkmalen des Anspruches 1 gelöst.
Hiernach ist also vorgesehen, daß die Haltevorrichtung gekennzeichnet ist durch ein im Bereich des Aufnahmeschlitzes anbringbares Koppelteil, ein an dem von dem Steckplatz abgekehrten Ende der Steckkarte festlegbares Haltestück und ein an dem Koppelteil und dem Haltestück angebrachtes oder anbringbares Spannstück, mit dem der Abstand zwischen dem Koppelteil und dem Haltestück verkürzbar ist.

Zum einen ist die Haltevorrichtung auf diese Weise einfach an dem dem Aufnahmeschlitz gegenüberliegenden freien Rand der Steckkarte mit ihrem Haltestück anbringbar und dann mit dem Spannstück festlegbar. Zum anderen wird die Steckkarte, auch wenn sie relativ lang ist, sicher gehalten, da das Haltestück an ihrem freien Ende angreift. Ein Lockern oder Herausfallen der Steckkarte aus dem Steckplatz ist damit dauerhaft verhindert.

Eine einfach aufgebaute, kostengünstige und dabei leicht handhabbare Haltevorrichtung wird durch die Maßnahmen erhalten, daß das Koppelteil auf den Steckplatz aufsteckbar und mittels Greiferelementen festlegbar ist, daß das Haltestück mindestens einen den zugeordneten Rand der Steckkarte umgreifenden Haken aufweist, und daß das Koppelteil eine Verzahnung mit flachen und steilen Flanken aufweist, mit der es durch einen mit einem Rastelement versehenen Führungsabschnitt des Haltestückes zum Verkürzen des Abstandes zwischen dem Koppelteil und dem Haltestück hindurchziehbar ist, wobei die flachen Flanken in Zugrichtung und die steilen Flanken entgegen der Zugrichtung gerichtet sind und das Rastelement sich entgegen der Zugrichtung an den steilen Flanken abstützt.

Ist vorgesehen, daß das Spannstück mit seinem einen Ende an dem Haltestück und im Abstand zu dem Haltestück, der größer ist als die Ausdehnung der Steckkarte von dem Steckplatz bis zu ihrem von dem Steckplatz abgekehrten Ende, in einem Zwischenabschnitt an dem Koppelteil fest angebracht ist, und daß das Spannstück mit seinem anderen, freien Ende durch den Führungsabschnitt gezogen ist, so sind das Koppelteil, das Haltestück und das Spannstück unverlierbar zu einer Einheit miteinander verbunden, so daß sich weitere Vorteile bei der Handhabung ergeben. Ferner kann die derart gebildete Einheit auf einfache Weise hergestellt werden.

Das Koppelteil kann an dem Steckplatz leicht dadurch angebracht werden, daß das Koppelteil ein auf seinem dem Steckplatz zugekehrten Innenbereich angeordnetes, im Querschnitt U-förmiges Blechteil mit ausgescherten, gegen die Zugrichtung wirkenden Greifhaken aufweist, und daß das Blechteil außen von einem aufgesteckten oder angeformten Kunststoffmantel umgeben ist.

Für die Fertigung ist weiterhin vorteilhaft, daß das Spannstück aus Kunststoff ausgebildet und mit seinem einen Ende an dem Haltestück und mit seinem Zwischenabschnitt an dem Koppelteil angeformt ist.

Die Erfindung wird nachfolgend anhand von Ausführungsbeispielen unter Bezugnahme auf die Figuren näher erläutert. Es zeigen:
- Fig. 1: eine in einen Steckplatz eingesetzte Steckkarte und eine Haltevorrichtung mit einem an dem Steckplatz angebrachten Koppelteil und einem an dem freien Ende der Steckkarte angebrachten Haltestück,
- Fig. 2A: ein Ausführungsbeispiel für die in Fig. 1 verwendete Haltevorrichtung,
- Fig. 2B: eine Seitenansicht einer in einem Steckplatz eingesetzten Steckkarte und eine daran anzulegende Haltevorrichtung,
- Fig. 3: verschiedene Ansichten eines Koppelteils der Haltevorrichtung,
- Fig. 4A: ein Haltestück der Haltevorrichtung mit einem durchgeführten Spannstück in Seitenansicht,
- Fig. 4B: das Haltestück nach Fig. 4A in teilweise geschnittener Draufsicht,
- Fig.5: zwei Ausführungsbeispiele für eine Haltevorrichtung mit einem Haltestück, einem Spannstück und einem Koppelteil bzw. einem Verbindungsteil,
- Fig. 6: eine an einem Steckplatz und einer Platine festgelegte Haltevorrichtung, teilweise geschnitten, in Draufsicht, und
- Fig. 7: eine Bildfolge zum Festlegen der Haltevorrichtung an dem Steckplatz einerseits und der Steckkarte andererseits.

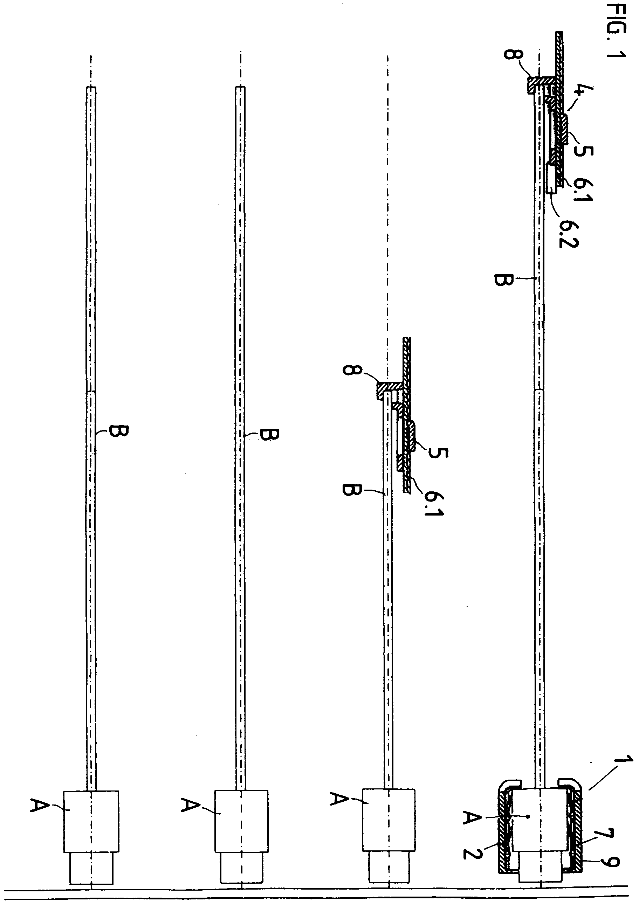

Die Fig. 1 zeigt vier Steckplätze (slots) A mit eingesetzten Steckkarten B zweier unterschiedlicher Längen. An dem obersten Steckplatz A ist eine Haltevorrichtung mit einem im wesentlichen U-förmigen Koppelteil 1 aufgesetzt, während an dem von dem Steckplatz A abgekehrten Ende der Steckkarte B ein Haltestück 4 mit Haken 8 angesetzt ist. In der zweitobersten Abbildung ist eine kürzere Steckkarte B mit ebenfalls angesetztem Haltestück 4 dargestellt.

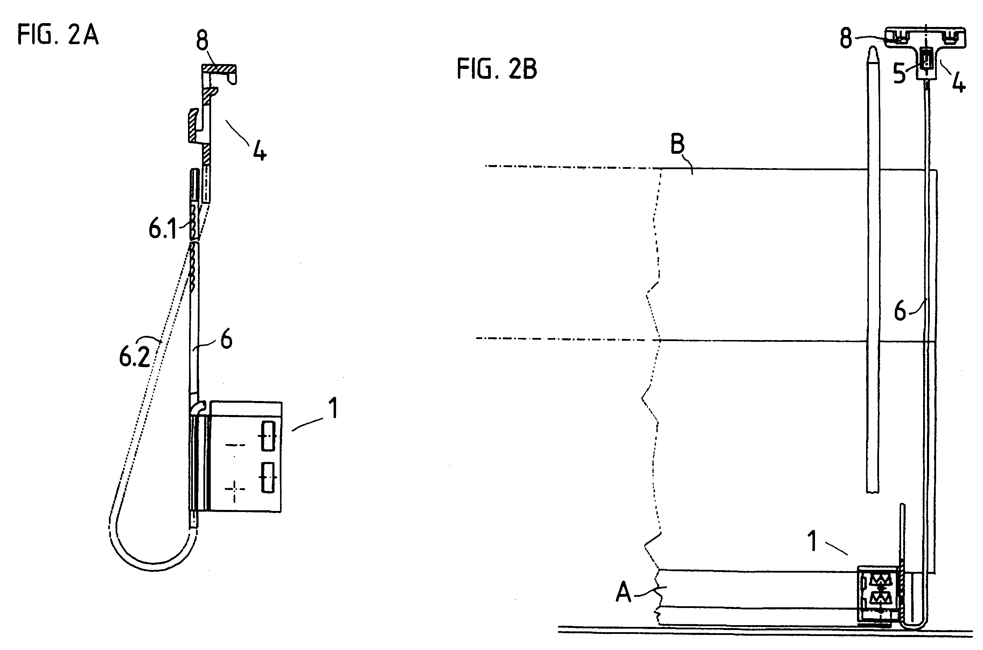

Wie beispielsweise in der Fig. 2A gezeigt, sind das Koppelteil 1 und das Haltestück 4 mittels eines Spannstückes 6 in Form eines Bandes oder einer Schnur miteinander verbunden. Das Koppelteil 1 weist auf seiner dem Steckplatz A zugekehrten Innenseite eine Blechanbindung 7 auf, in der Greiferelemente 2 in Form durchgescherter Greifhaken ausgebildet sind, die sich in Richtung zu dem freien Ende der Leiterplatte bzw. zu dem Haltestück an der Außenseite des Steckplatzes A abstützen und bei Zug in dieser Richtung festhaken. Auf der Außenseite trägt das Koppelteil 1 einen Kunststoffmantel 9, mit dem eine Isolation nach außen und/oder eine einstückige Verbindung mit dem Spannstück 6 gebildet wird. An dem einen Ende des Spannstückes 6 ist das Haltestück 4, das wie das Spannstück 6 ebenfalls vorzugsweise aus Kunststoff besteht, über ein Filmscharnier 6.2 angeformt, so daß sich eine Einheit aus dem Kunststoffmantel 9 des Koppelteils 1, dem Spannstück 6 sowie dem Haltestück 4 ergibt. Mit seinem anderen Ende ist das Spannstück 6 durch einen Führungsabschnitt der Haltevorrichtung gezogen. Dabei greift eine an dem Spannstück 6 vorgesehene Verzahnung 6.1, die in Zugrichtung flache Zahnflanken und entgegen der Zugrichtung steile Zahnflanken aufweist, in einen Rasthaken 5, der sich entgegen der Zugrichtung an den steilen Zahnflanken abstützt.

Auf seiner der Steckkarte B zugekehrten Seite weist das Haltestück 4 mindestens einen Haken 8 auf, mit dem es die Steckkarte B an dem von dem Steckplatz A abgekehrten freien Rand umgreift. Zum Festlegen der Steckkarte B in dem Steckplatz A wird das mit der Verzahnung 6.1 versehene andere Ende des Spannstückes 6 in Richtung von dem freien Ende der Steckkarte B weg gezogen, wobei das Haltestück 4 in Richtung auf das freie Ende der Steckkarte B geschoben wird, so daß die Haken 6 fest an dem freien Rand der Steckkarte B in Anlage kommen und diese sicher in dem Steckplatz A halten. Im gespannten Zustand des Spannstückes 6 stützt sich der Rasthaken 5 an der oder den zugekehrten freien Flanken der Verzahnung 6.1 ab, so daß sich das Spannstück 6 entgegen der Zugrichtung des anderen Endes nicht von selbst lösen kann.

In Fig. 2A ist die Einheit aus dem Koppelteil 1, dem Haltestück 4 und dem Spannstück 6 mit dem Verzahnungsabschnitt 6.1 und dem Filmscharnier 6.2 dargestellt, wobei das mit der Verzahnung 6.1 versehene andere Ende des Haltestückes 4 noch nicht in den Führungsabschnitt des Haltestückes 4 eingeführt ist. Das eine Ende des Spannstückes 6 ist an dem von dem Haken 8 abgelegenen Ende des Haltestückes 4 angebracht, während ein Zwischenstück des Spannstückes 6 an dem Koppelteil 1 festgelegt ist.

Fig. 2B zeigt einen Abschnitt einer in einen Steckplatz A eingeführten Steckkarte B sowie die daran anzulegende Haltevorrichtung mit dem Koppelteil 1 und dem Haltestück 4 sowie dem Spannstück 6. Beim Haltestück 4 sind die beiden angeformten Haken 8 sowie der angeformte Rasthaken 5 zu erkennen.

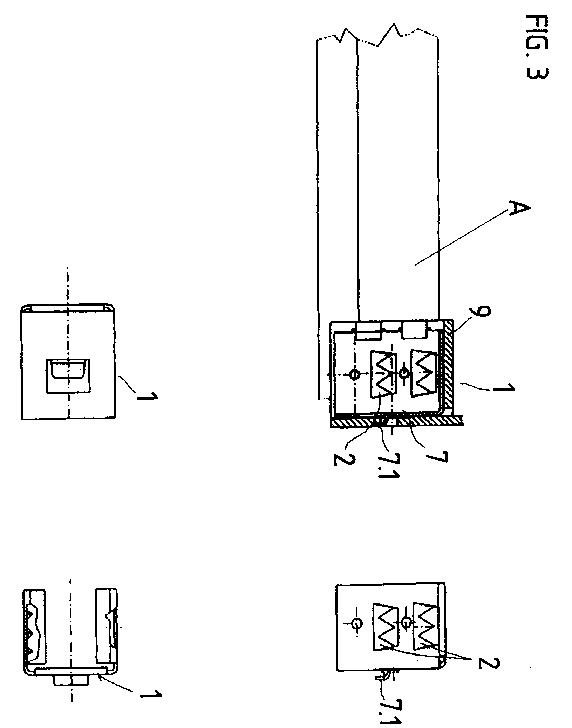

In Fig. 3 sind unterschiedliche Darstellungen des Koppelteils 1 gezeigt, wobei der Kunststoffmantel 9 in der linken oberen Darstellung im Querschnitt zu sehen ist. Die auf der Innenseite liegende Blechanbindung 7 ist mit einer ausgebogenen Lasche 7.1 versehen, mit der die Blechanbindung 7 an dem Kunststoffmantel 9 festgelegt ist, wie die beiden oberen Abbildungen zeigen. Die beiden unteren Abbildungen zeigen die Blechanbindung 7 und in rückwärtiger Ansicht bzw. in Draufsicht, wobei die ausgebogene Lasche ebenfalls ersichtlich ist.

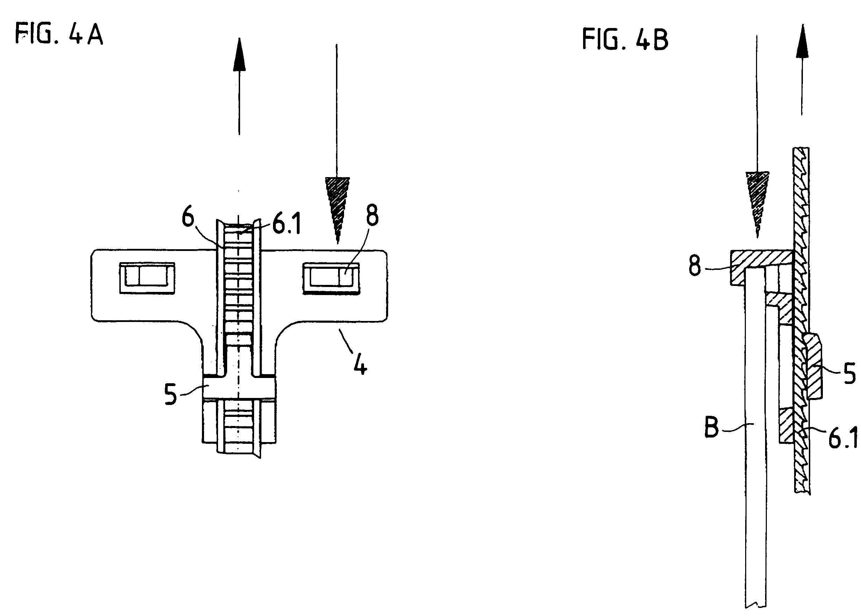

Die Fig. 4A und 4B geben das Haltestück 4 deutlicher wieder, wobei es in Fig. 4A in Seitenansicht von der den Haken 8 abgekehrten Seite dargestellt ist. Unter dem Rasthaken 5 ist die Verzahnung 6.1 des Spannstückes in Form des Bandes 6 hindurchgeführt, und der Rasthaken 5 stützt sich, wie deutlicher in dem in Fig. 4B gezeigten Längsschnitt zu sehen ist, an einer steilen Flanke der Verzahnung 6.1 ab. Gemäß Fig. 4B ist der Rasthaken 8 an dem freien Ende der Steckkarte B angesetzt. Mit den Pfeilen ist einmal die Aufschieberichtung des Haltestückes 4 und zum anderen die Zugrichtung des freien Endes des Spannstückes 6 gezeigt.

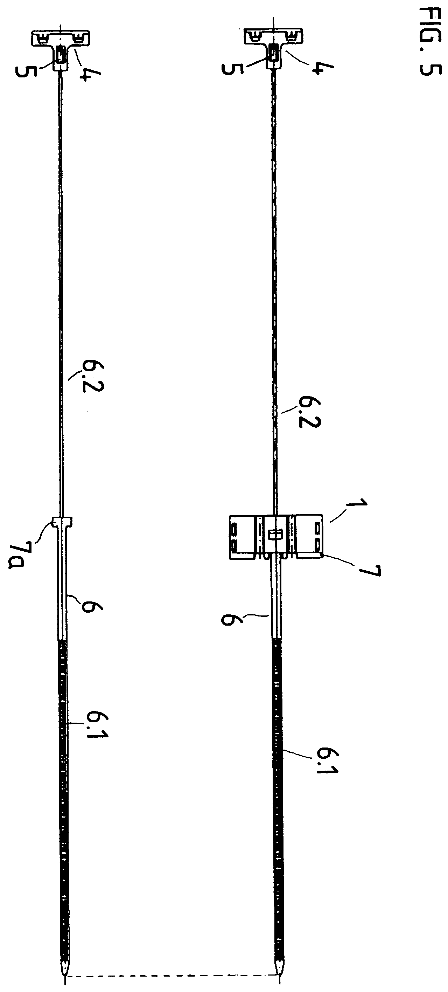

Fig. 5 zeigt in der oberen Abbildung die Einheit der Haltevorrichtung aus Haltestück 4 mit Rasthaken 5, Spannstück 6 und Koppelteil 1. Die Verzahnung 6.1 ist hierbei an dem von dem Koppelteil 1 weggerichteten freien Endabschnitt des Spannstückes 6 vorgesehen.

In der unteren Abbildung ist ein Verbindungsteil 7a dargestellt, mit dem das Spannstück 6 an dem Koppelteil 1 angebracht wird.

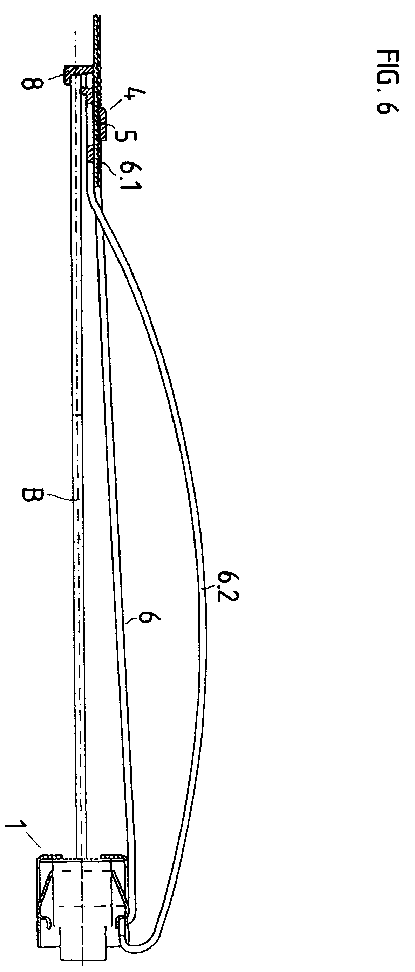

In Fig. 6 ist eine an einer Steckkarte B angelegte Haltevorrichtung mit dem Koppelteil 1, dem Spannstück 6 sowie dem Haltestück 4 in teilweise geschnittener Draufsicht dargestellt, wobei ein Haken 8 an dem freien Ende der Steckkarte B angesetzt ist. Das Spannstück 6 ist durch den Führungsabschnitt des Haltestückes 4 gezogen und gespannt, so daß die Steckkarte B in Richtung des Koppelteils 1 angezogen ist. Das Koppelteil 1 ist dabei beispielsweise mit einem Kunststoffmantel umspritzt, und auch an dem Koppelteil 1 ist das bandförmige Bandstück 6 angebracht.

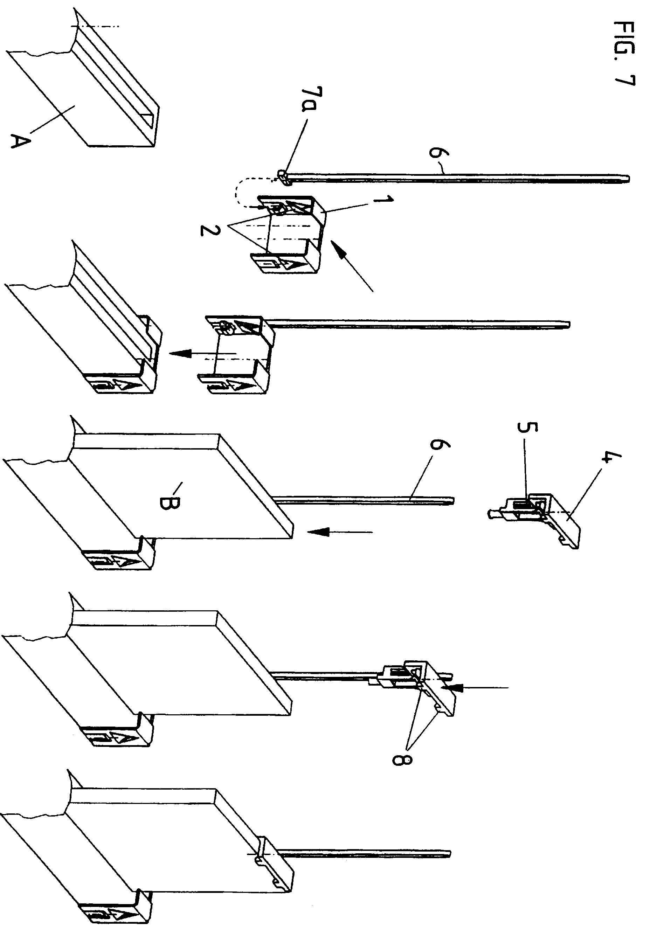

In Fig. 7 ist eine Bildfolge dargestellt, aus der die einzelnen Schritte beim Festlegen der Haltevorrichtung an der Steckkarte B ersichtlich sind. Im ersten Schritt (linkes Teilbild) wird das Spannstück 6 mit dem Verbindungsteil 7a an dem Koppelteil 1 angebracht. Im zweiten Schritt wird das Koppelteil 1 auf den Steckplatz A aufgesetzt, wobei sich die durchgescherten Haken 2 entgegen der Aufsetzrichtung an der Außenseite des Steckplatzes A abstützen. Anschließend wird das Haltestück 4 auf das Spannstück 6 geschoben und an dem von dem Steckplatz abgekehrten freien Rand der Steckkarte B mit den Greifhaken 2 festgelegt.

## Patentansprüche

1. Haltevorrichtung für eine in einen Steckplatz eingesetzte Steckkarte, gekennzeichnet durch
einen im Bereich des Aufnahmeschlitzes (A) anbringbares Koppelteil (1), ein an dem von dem Steckplatz (A) abgekehrten Ende der Steckkarte (B) festlegbares Haltestück (4) und
ein an dem Koppelteil (1) und dem Haltestück (4) angebrachtes oder anbringbares Spannstück (6), mit dem der Abstand zwischen dem Koppelteil (1) und dem Haltestück (4) verkürzbar ist.

2. Haltevorrichtung nach Anspruch 1,
dadurch gekennzeichnet,
daß das Koppelteil (1) auf den Steckplatz (A) aufsteckbar und mittels Greiferelementen (2) festlegbar ist,
daß das Haltestück (4) mindestens einen den zugeordneten Rand der Steckkarte (B) umgreifenden Haken (8) aufweist, und
daß das Koppelteil (1) eine Verzahnung (6.1) mit flachen und steilen Flanken aufweist, mit der es durch einen mit einem Rastelement (5) versehenen Führungsabschnitt des Haltestückes (4) zum Verkürzen des Abstandes zwischen dem Koppelteil (1) und dem Haltestück (4) hindurchziehbar ist, wobei die flachen Flanken in Zugrichtung und die steilen Flanken entgegen der Zugrichtung gerichtet sind und das Rastelement sich entgegen der Zugrichtung an den steilen Flanken abstützt.

3. Haltevorrichtung nach Anspruch 1 oder 2,
dadurch gekennzeichnet,
daß das Spannstück (6) mit seinem einen Ende an dem Haltestück (4) und im Abstand zu dem Haltestück (4), der größer ist als die Ausdehnung der Steckkarte (B) von dem Steckplatz (A) bis zu ihrem von dem Steckplatz (A) abgekehrten Ende, in einem Zwischenabschnitt an dem Koppelteil (1) fest angebracht ist, und
daß das Spannstück (6) mit seinem anderen, freien Ende durch den Führungsabschnitt gezogen ist.

4. Haltevorrichtung nach einem der Ansprüche 1 bis 3,
dadurch gekennzeichnet,
daß das Koppelteil (1) ein auf seinem dem Steckplatz (A) zugekehrten Innenbereich angeordnetes, im Querschnitt U-förmiges Blechteil (7) mit ausgescherten, gegen die Zugrichtung wirkenden Greifhaken (2) aufweist, und
daß das Blechteil (7) außen von einem aufgesteckten oder angeformten Kunststoffmantel (9) umgeben ist.

5. Haltevorrichtung nach einem der Ansprüche 1 bis 4,
dadurch gekennzeichnet,
daß das Spannstück (6) aus Kunststoff ausgebildet und mit seinem einen Ende an dem Haltestück (4) und mit seinem Zwischenabschnitt an dem Koppelteil (1) angeformt ist.
